# DEMANDE DE BREVET EUROPEEN

(11) **EP 2 667 416 A1**
(43) Date de publication de la demande: **27.11.2013**
(21) Numéro de dépôt: 13168972.1
(22) Date de dépôt: 23.05.2013
(51) Int. Cl.: H01L 29/423, H01L 29/775, H01L 29/06, H01L 29/66, H01L 29/41, B82Y 40/00, B82Y 10/00

(54) **Transistor à base de nanofil, procédé de fabrication du transistor et composant semi-conducteur intégrant le transistor**

(30) Priorité: 25.05.2012 FR 1254822
(71) Demandeur: Commissariat à l'Énergie Atomique et aux Énergies Alternatives, 75015 Paris (FR); CNRS, 75794 Paris Cedex 16 (FR); Universite Joseph Fourier - Grenoble, 38041 Grenoble Cedex 9 (FR)
(72) Inventeur: Rosaz, Guillaume, 73800 Les Marches (FR); Gentile, Pascal, 38500 Voiron (FR); Baron, Thierry, 26100 Romans (FR); Salem, Bassem, 38360 Fontaine (FR); Pauc, Nicolas, 38360 Sassenage (FR)
(74) Mandataire: Novaimo

(57) **Abrégé**

Le transistor (100) comprend un nanofil (101) formant au moins partiellement un canal du transistor (100), un contact de source (102) disposé au niveau d'une première extrémité longitudinale (103) du nanofil (101), un contact de drain (104) disposé au niveau d'une seconde extrémité longitudinale (105) du nanofil (101), et une grille (106) disposée au niveau du nanofil (101) entre le contact de source (102) et le contact de drain (104). En outre, une portion de la grille (106) recouvre, avec interposition d'un matériau diélectrique (107), une portion correspondante du contact de source (102) et/ou du contact de drain (104) disposée le long du nanofil (101) entre ses deux extrémités longitudinales (103, 105).

## Description

### Domaine technique de l'invention

L'invention concerne le domaine des transistors appliqué aux nanotechnologies comme par exemple les FET pour l'anglais « Field Effect Transistor » ou les transistors à effets de champs

L'invention a pour objet plus particulièrement un transistor à base de nanofil.

### État de la technique

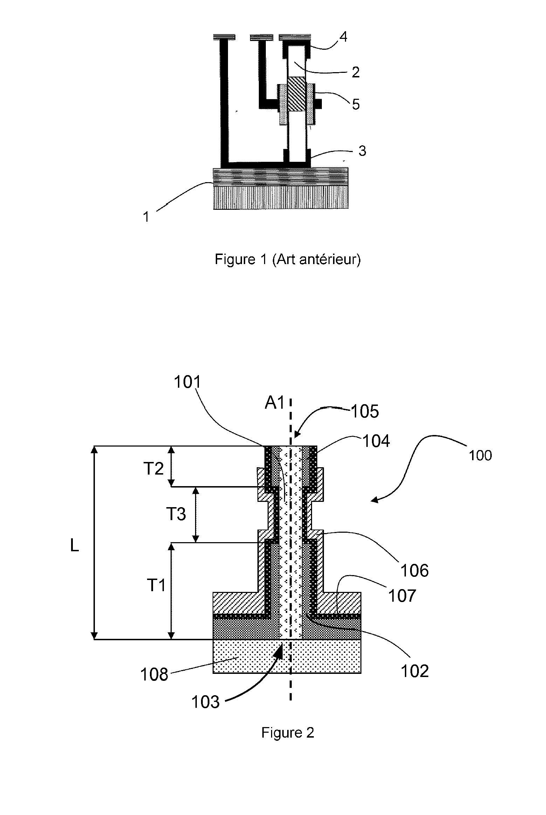

Le document W02006/135336 décrit comme illustré à la figure 1 un transistor formé sur un substrat 1. Un nanofil 2 s'élève du substrat 1 avec interposition d'un contact de source 3. L'extrémité du nanofil 2 opposée au substrat 1 est recouverte par un contact de drain 4. Une grille 5 du transistor est interposée entre le contact de source 3 et le contact de drain 4, et entoure une portion du nanofil 2.

Un tel transistor n'est pas totalement satisfaisant car il possède une résistance d'accès importante.

Il résulte donc une problématique d'amélioration du transistor tel que décrit précédemment.

### Objet de l'invention

Le but de la présente invention est de proposer une solution permettant de diminuer la résistance d'accès du transistor.

On tend vers ce but en ce que le transistor comprend un nanofil formant au moins partiellement un canal du transistor, un contact de source disposé au niveau d'une première extrémité longitudinale du nanofil, un contact de drain disposé au niveau d'une seconde extrémité longitudinale du nanofil, et une grille disposée au niveau du nanofil entre le contact de source et le contact de drain, une portion de la grille recouvrant, avec interposition d'un matériau diélectrique, une portion correspondante du contact de source et/ou du contact de drain disposée le long du nanofil entre ses deux extrémités longitudinales.

Avantageusement, la portion correspondante du contact de source et/ou du contact de drain, disposée le long du nanofil entre ses deux extrémités longitudinales, est distincte du nanofil et recouvre une partie de surface extérieure du nanofil.

Selon une mise en oeuvre, le nanofil comporte trois tronçons échelonnés selon sa longueur entre ses deux extrémités longitudinales, un premier tronçon étant enrobé par le contact de source, un deuxième tronçon étant enrobé par le contact de drain, et un troisième tronçon étant enrobé au moins partiellement par la grille avec interposition du matériau diélectrique.

Avantageusement, la grille enrobe aussi au moins partiellement, avec interposition du matériau diélectrique, le contact de source, et/ou le contact de drain.

De préférence, la longueur de la portion de grille recouvrant, avec interposition du matériau diélectrique, la portion correspondante du contact de source et/ou du contact de drain est comprise entre 5% et 90% de la longueur dudit contact, et plus particulièrement entre 30% et 70%, lesdites longueurs de portions de grille et de contact étant orientées selon la longueur du nanofil.

De préférence, les contacts de source et de drain forment chacun un fourreau entourant respectivement les premier et deuxième tronçons du nanofil, et la grille entoure totalement au moins une partie du troisième tronçon du nanofil, et totalement au moins une portion du contact de source et/ou du contact de drain avec interposition du matériau diélectrique.

L'invention est aussi relative à un composant semi-conducteur comprenant au moins un transistor.

L'invention est aussi relative à un procédé de fabrication d'un transistor comprenant la phase suivante :
- Former un nanofil destiné à servir au moins partiellement de canal du transistor,
- Former simultanément un contact de source au niveau d'une première extrémité longitudinale du nanofil, et un contact de drain au niveau d'une seconde extrémité longitudinale du nanofil opposée à la première extrémité longitudinale,
- Former une grille de sorte qu'une portion de la grille recouvre, avec interposition d'un matériau diélectrique, une portion correspondante du contact de source et/ou de drain disposée le long du nanofil entre ses deux extrémités longitudinales.

Selon une mise en oeuvre, la phase de formation du contact de source et du contact de drain comprend les étapes suivantes :
- Recouvrir la surface extérieure du nanofil, au moins selon sa longueur, d'un matériau destiné à former le contact de source et le contact de drain,
- Graver ledit matériau destiné à former le contact de source et le contact de drain entre les deux extrémités longitudinales du nanofil de sorte à délimiter le contact de source et le contact de drain.

Selon une mise en oeuvre, avant de graver le matériau destiné à former le contact de source et le contact de drain, la phase de formation du contact de source et du contact de drain comporte une étape de délimitation de la zone à graver par formation de deux masques de gravure :
- un premier masque de gravure étant formé sur une partie du matériau destiné à former le contact de source et le contact de drain au niveau d'une base du nanofil située à une interface entre une des extrémités longitudinales du nanofil et un substrat à partir duquel s'élève le nanofil, et
- un second masque de gravure étant formé sur une partie du matériau destiné à former le contact de source et le contact de drain au niveau de l'extrémité longitudinale du nanofil opposée au substrat.

De préférence, le second masque de gravure est formé sur une couche sacrificielle déposée, préalablement à la formation du second masque de gravure, sur le premier masque de gravure, et avant de réaliser l'étape de gravure du matériau destiné à former le contact de source et le contact de drain, cette couche sacrificielle est retirée.

Selon une mise en oeuvre, le procédé comporte la formation d'une pluralité de transistors, chacun formé à partir d'un, ou plusieurs, nanofil associé, et le second masque de gravure est formé par le dépôt d'une couche formant, après retrait de la couche sacrificielle, une membrane suspendue reliant une pluralité de nanofils au niveau de leurs extrémités longitudinales opposées au substrat avec interposition d'une partie du matériau destiné à former le contact de source et le contact de drain.

De manière avantageuse la phase de formation de la grille comporte :
- le dépôt d'un oxyde de grille, formant en outre le matériau diélectrique, de sorte à recouvrir au moins le contact de source, le contact de drain et la partie de nanofil située entre le contact de source et le contact de drain,
- le dépôt, sur l'oxyde de grille, d'un matériau destiné à former la grille,
- la structuration du matériau déposé sur l'oxyde de grille pour former la grille.

Avantageusement, la structuration comprend le retrait d'une partie du matériau destiné à former la grille recouvrant l'oxyde de grille au niveau de l'extrémité longitudinale du nanofil opposée au substrat, et d'une autre partie du matériau destiné à former la grille recouvrant l'oxyde de grille au niveau de la base du nanofil.

Le procédé peut aussi comporter une phase de formation d'interconnexions de grille, de source et de drain, les interconnexions de source et de drain étant formées par retrait d'une partie de l'oxyde de grille au niveau des zones où le matériau de grille a été retiré lors de la structuration de la grille.

L'invention est aussi relative à un support d'enregistrement de données lisible par un calculateur, sur lequel est enregistré un programme informatique comprenant des moyens de codes de programme informatique de mise en oeuvre des phases et/ou des étapes d'un procédé de fabrication tel que décrit.

L'invention est aussi relative à un programme informatique comprenant un moyen de codes de programme informatique adapté à la réalisation des phases et/ou des étapes d'un procédé de fabrication tel que décrit, lorsque le programme est exécuté par un calculateur.

### Description sommaire des dessins

D'autres avantages et caractéristiques ressortiront plus clairement de la description qui va suivre de modes particuliers de réalisation de l'invention donnés à titre d'exemples non limitatifs et représentés sur les dessins annexés, dans lesquels :
- la figure 1 illustre une vue en coupe d'un transistor selon l'art antérieur,
- la figure 2 illustre une vue en coupe d'un transistor selon un mode de réalisation de la présente invention,
- la figure 3 représente schématiquement un procédé de fabrication d'un transistor selon la figure 2,
- les figures 4 à 18 représentent des vues en coupe d'un transistor en cours de réalisation à différentes étapes du procédé de fabrication.

### Description de modes préférentiels de l'invention

Le transistor décrit ci-après diffère de celui de l'art antérieur notamment en ce qu'une grille dudit transistor comporte une partie située en vis-à-vis d'une portion d'un contact de source du transistor et/ou d'une portion d'un contact de drain du transistor située le long du nanofil entre ses deux extrémités longitudinales.

Sur la figure 2, le transistor 100 comprend un nanofil 101 formant au moins partiellement un canal du transistor 100. Un contact de source 102 du transistor 100 est disposé au niveau d'une première extrémité longitudinale 103 du nanofil 101, et un contact de drain 104 du transistor 100 est disposé au niveau d'une seconde extrémité longitudinale 105 du nanofil 101. Une grille 106 est disposée au niveau du nanofil entre le contact de source 102 et le contact de drain 104, de sorte qu'une portion de la grille 106 recouvre, avec interposition d'un matériau diélectrique 107, une portion correspondante du contact de source 102 et/ou du contact de drain 104 disposée le long du nanofil 101 entre ses deux extrémités longitudinales 103 et 105.

Par « contact de source et/ou contact de drain », on entend des contacts configurés de sorte à injecter et/ou extraire des charges dans le transistor. En fait, ces contacts de source et/ou de drain forment avec le canal des zones de recouvrement où les charges peuvent être injectées dans le canal et/ou extraites du canal. Ces zones de recouvrement forment alors la source et le drain du transistor. Autrement dit, les contacts de source et de drain sont ici de préférence distincts du nanofil associé.

Le recouvrement permet de limiter la résistance d'accès, et le mode de réalisation, où le contact de source et le contact de drain ont chacun une portion recouverte par la grille avec interposition du matériau diélectrique 107 le long du nanofil, est préféré dans le sens où il limite au maximum cette résistance d'accès.

Sur l'exemple particulier de la figure 2, le contact de source 102 et le contact de drain 104 sont distincts du nanofil 101 et recouvre chacun partiellement le nanofil 100. Autrement dit, la portion correspondante du contact de source 102 et/ou du contact de drain 104, disposée le long du nanofil 101 entre ses deux extrémités longitudinales et recouverte par la grille 106 avec interposition du matériau diélectrique 107, recouvre une partie de la surface extérieure du nanofil 101, et est distincte du nanofil 101.

Typiquement, le matériau diélectrique 107 est aussi appelé oxyde de grille.

Sur la figure 2, le nanofil 100 comporte notamment trois tronçons T1, T2, T3 échelonnés selon sa longueur L entre ses deux extrémités longitudinales 103 et 105. Un premier tronçon T1 est enrobé par le contact de source 102, un deuxième tronçon T2 est enrobé par le contact de drain 104, et un troisième tronçon T3 est enrobé au moins partiellement par la grille 106 avec interposition du matériau diélectrique 107. En fait, on peut considérer qu'au moins le tronçon T3 du nanofil correspond au canal du transistor 100 auquel est associée la grille 106. Par ailleurs, la grille 106 enrobe aussi au moins partiellement, avec interposition du matériau diélectrique 107, le contact de source 102, de préférence au niveau de l'interface entre les premier et troisième tronçons T1, T3, et/ou le contact de drain 104, de préférence au niveau de l'interface entre les deuxième et troisième tronçons T2, T3.

Par « enrober », on entend un recouvrement à 360 degrés autour de l'axe longitudinal A1 du nanofil 101. Autrement dit, le contact de source 102 et le contact de drain 104 forment chacun un fourreau entourant respectivement les premier et deuxième tronçons T1, T2 du nanofil 101 notamment autour de l'axe A1, et sont avantageusement en contact direct avec la surface extérieure du nanofil 101. La grille 106 entoure totalement au moins une partie du troisième tronçon T3 du nanofil 101, et totalement au moins une portion du contact de source 102 et/ou du contact de drain 104 avec interposition du matériau diélectrique 107. Ainsi, le matériau diélectrique peut être en contact direct avec le nanofil 101 au niveau du troisième tronçon T3, et en contact direct avec une portion du contact de source 102 et/ou du contact de drain 104. La grille 106 est ensuite en contact direct avec le matériau diélectrique 107 notamment de sorte à assurer un effet de champ entre le contact de source 102 et le contact de drain 104.

Par ailleurs, le nanofil 101 s'élève à partir de l'une de ses extrémités longitudinales d'un substrat 108. Le nanofil 101 peut donc être en contact direct avec le substrat 108. Sur la figure 2, l'extrémité située au niveau du substrat 108 est l'extrémité 103 associée au contact de source 102, cependant le schéma pourrait être inversé de sorte que cela soit l'extrémité 105 et le contact de drain 104 qui soient situés au niveau du substrat 108.

Par longueur du nanofil 101, on entend la distance séparant ses deux extrémités longitudinales 103 et 105, notamment représentée par la référence L à la figure 2. La longueur des tronçons est définie parallèlement à la dimension définissant la longueur du nanofil 101 entre ses deux extrémités longitudinales.

De manière avantageuse, la longueur de la portion de grille recouvrant, avec interposition du matériau diélectrique 107, la portion correspondante du contact de source et/ou du contact de drain est comprise entre 5% et 90 % de la longueur du contact, et plus particulièrement entre 30% et 70%. Les longueurs de portions de grille et de contact sont orientées selon la longueur du nanofil.

Un composant semi-conducteur peut comprendre au moins un transistor tel que décrit ci-avant, ou obtenu selon le procédé décrit ci-après.

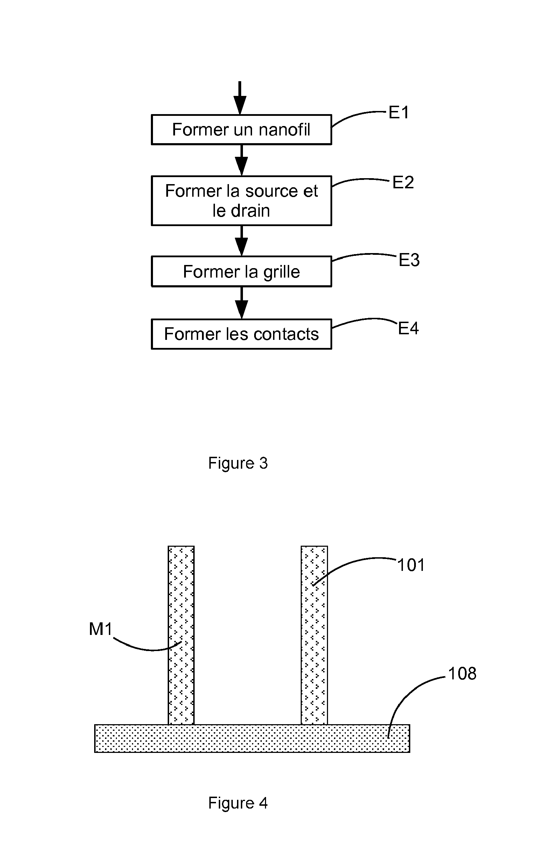

La suite de la description est notamment relative à un procédé de fabrication d'au moins un transistor tel que décrit ci-avant. Un tel procédé est illustré aux figures 2 à 18. Sur les figures 4 à 18, on a chaque fois représenté deux nanofils de sorte à former deux transistors. Cependant, le procédé ne se limite pas à deux transistors. En effet, il peut y avoir un unique nanofil destiné à former un unique transistor, ou au moins deux nanofils chacun destiné à former un transistor.

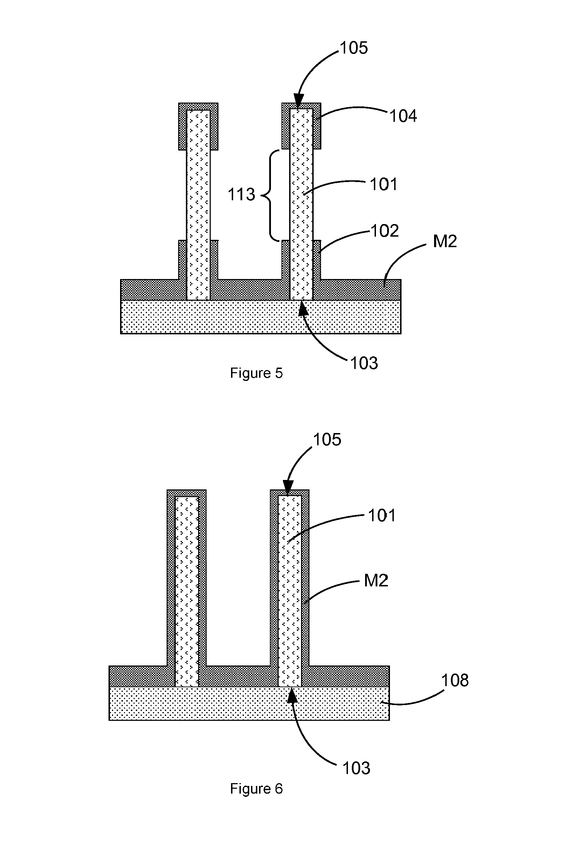

De manière générale, le procédé de fabrication d'au moins un transistor tel illustré à la figure 3 comprend une phase E1 dans laquelle on forme un nanofil 101 (figure 4) destiné à servir au moins partiellement de canal du transistor, ensuite on forme E2 simultanément un contact de source 102 au niveau d'une première extrémité longitudinale 103 du nanofil 101, et un contact de drain 104 au niveau d'une seconde extrémité longitudinale 105 du nanofil 101 opposée à la première extrémité longitudinale 103 (figure 5). Enfin, on forme E3 une grille 106 de sorte qu'une portion de la grille 106 recouvre, avec interposition d'un matériau diélectrique 107, une portion correspondante du contact de source 102 et/ou du contact de drain 104, ladite portion correspondante étant disposée le long du nanofil entre ses deux extrémités longitudinales 103, 105 (figure 2). La grille 106, le contact de source 102 et le contact de drain 104 forment le transistor dont le canal est au moins partiellement délimité par le nanofil 101.

La figure 4 illustre une réalisation particulière de la phase dans laquelle on forme le nanofil 101. Chaque nanofil 1 est en fait une structure verticale s'élevant par exemple d'un substrat 108. Cette structure verticale à base de matériaux semi-conducteurs peut être obtenue par croissance ou par gravure de matériaux IV-IV (par exemple Si, SiGe, Ge,..) ou III-V (InAs, InP, GaAs, ...) ou II-VI (ZnO, ...). Le substrat 108 peut être un monocristal, un polycristal, métal ou un matériau amorphe. Le matériau de la structure verticale est désigné par M1.

De manière avantageuse, la phase de formation du contact de source et du contact de drain comprend une étape de recouvrement de la surface extérieure du nanofil 101, au moins selon sa longueur, d'un matériau M2 destiné à former le contact de source 102 et le contact de drain 104 (figure 6). En fait, l'étape de recouvrement peut être réalisée par un dépôt d'un métal de contact de source et de contact de drain par exemple selon une méthode choisie parmi une pulvérisation cathodique, un dépôt CVD (pour dépôt chimique en phase vapeur), un dépôt PECVD (pour dépôt chimique en phase vapeur assisté par plasma), un dépôt ALD (technique de dépôt de couches atomiques), un dépôt par pulvérisation magnétron, ou encore un dépôt MOCVD (pour dépôt chimique en phase vapeur utilisant des précurseurs métallo-organiques) ou PE-MOCVD (pour dépôt chimique en phase vapeur assisté par plasma utilisant des précurseurs métallo-organiques). Le matériau constituant le contact de source ou le contact de drain est noté M2, il peut être déposé comme sur la figure 6 par dépôt conforme. Le matériau M2 peut être un métal (par exemple Pt, Ni, Co, Pd, Ti, Al, etc) ou un semi-conducteur dégénéré comme le polysilicium dopé p ou n (respectivement 10¹⁹ atomes/cm³ de bore ou de phosphore par exemple)

Sur la figure 6, le matériau M2 recouvre totalement le nanofil et au moins une partie du substrat 108 à l'interface avec le nanofil. De préférence, le substrat 108 est entièrement recouvert par le matériau M2 sur la face du substrat 108 portant le ou les nanofils 101.

Avantageusement, afin de maîtriser la réalisation du procédé, le matériau M2 peut être gravé sélectivement par rapport au matériau M1.

En outre, la phase de formation du contact de source et du contact de drain comporte aussi une étape de gravure dudit matériau M2 destiné à former le contact de source 102 et le contact de drain 104 entre les deux extrémités longitudinales 103, 105 du nanofil 101 de sorte à délimiter le contact de source 102 et le contact de drain 104 comme illustré à la figure 5.

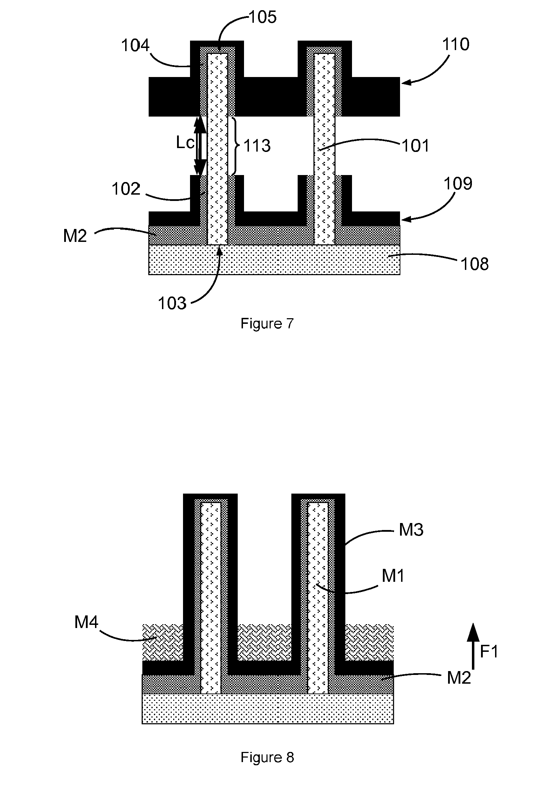

Selon une mise en oeuvre particulière, avant de graver le matériau M2 destiné à former le contact de source et le contact de drain, la phase de formation E2 du contact de source et du contact de drain comporte une étape de délimitation de la zone à graver 113 (figure 5) par formation de deux masques de gravure. Sur la figure 7, un premier masque de gravure 109 est formé sur une partie du matériau M2 destiné à former le contact de source 102 et le contact de drain 104 au niveau d'une base du nanofil 101 située à une interface entre une des extrémités longitudinales 103 du nanofil 101 et le substrat 108 à partir duquel s'élève le nanofil 101. Un second masque de gravure 110 est formé sur une partie du matériau M2 destiné à former le contact de source 102 et le contact de drain 104 au niveau de l'extrémité longitudinale 105 du nanofil 101 opposée au substrat 108. Dès lors, entre les deux masques de gravure 109 et 110, le matériau M2 peut être retiré par gravure sélective sur une longueur Lc associée à la zone 113 à graver. Autrement dit, le matériau M2 peut être gravé sélectivement par rapport aux matériaux utilisés pour former les masques de gravure 109 et 110, de sorte à retirer localement le matériau M2 jusqu'à la surface extérieure du nanofil 101 entre le premier masque et le second masque de gravure 109, 110.

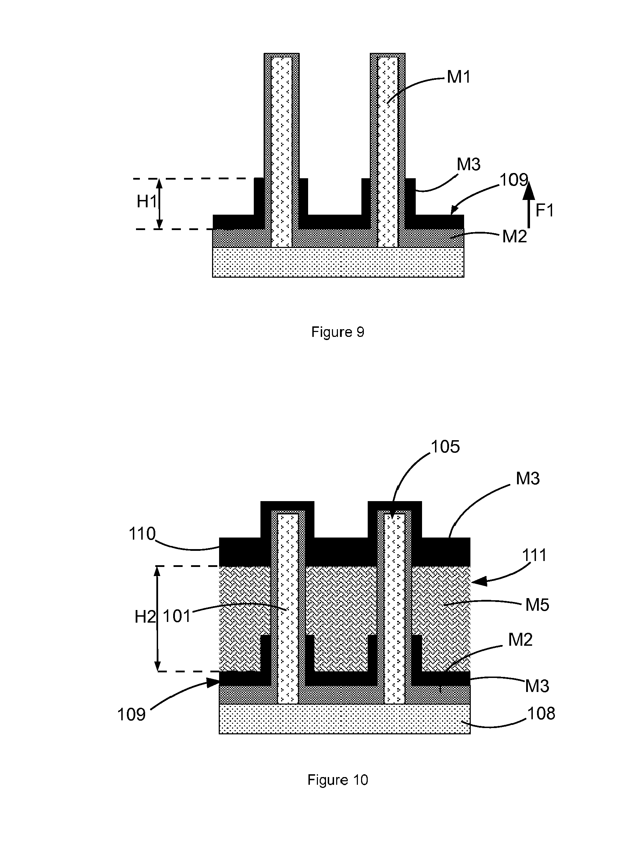

Le premier masque de gravure 109 peut être réalisé comme illustré aux figures 8 et 9. Dans un premier temps un matériau M3 est déposé par méthode conforme (isotrope), par exemple par pulvérisation cathodique, par pulvérisation magnétron, ou encore selon ALD, CVD, PECVD, MOCVD, ou PE-MOCVD. Le matériau M3 (figure 8) destiné à former le premier masque 109 (figure 7) est choisi de sorte que le matériau M2 puisse être gravé sélectivement par rapport au matériau M3 et inversement. Par ailleurs, M3 est aussi choisi de sorte à être gravé sélectivement par rapport à M1. Le dépôt conforme recouvre, avantageusement totalement, la couche en matériau M2. Après dépôt conforme du matériau M3, la hauteur H1 (figure 9) du futur contact de source selon la direction F1 est définie par le dépôt d'un masque sacrificiel en matériau M4 (figure 8). Ce matériau M4 peut être gravé sélectivement par rapport à M3 et inversement. Ainsi, pour passer de la figure 8 à la figure 9, on grave tout d'abord le matériau M3 sans préjudice au matériau M2, par exemple par gravure humide ou sèche, jusqu'au masque sacrificiel en matériau M4, puis on retire ensuite le matériau M4 de sorte à obtenir le premier masque 109 de la figure 9.

Selon une alternative, le matériau M3 n'est pas déposé par dépôt conforme mais plutôt par méthode non conforme (anisotrope) par exemple HDP-CVD (pour l'anglais High Density Plasma Chemical Vapor Deposition). Ceci permet de limiter les étapes du procédé, sans avoir recours à un masque sacrificiel comme dans le cas du dépôt conforme. La hauteur H1 est alors directement ajustée lors du dépôt du matériau M3 pour former le premier masque 109.

Le second masque de gravure 110 de la figure 7 peut être formé comme illustré à la figure 10 sur une couche sacrificielle 111 déposée, préalablement à la formation dudit second masque de gravure 110, sur le premier masque de gravure 109. Avant de réaliser l'étape de gravure du matériau M2 destiné à former le contact de source et le contact de drain, cette couche sacrificielle 111 est retirée. De sorte à laisser libre le matériau M2 sur la longueur Lc du canal désirée (figure 7).

Autrement dit, en partant de la figure 9, il est possible de réaliser le second masque 110 en déposant la couche sacrificielle 111 de matériau M5 (figure 10). Typiquement ce matériau M5 peut être une résine, un HDP-CVD oxyde, un HDP-CVD nitrure, ou encore le méthyl-siloxane. L'épaisseur H2 de cette couche 111, par rapport au substrat 108 déterminera ultérieurement la distance Lc entre les contacts de source et de drain du futur transistor. L'épaisseur H2 de cette couche 111 peut être amincie par gravure sèche afin d'obtenir une distance entre le contact de source et le contact de drain plus faible. Le matériau M5 peut être gravé sélectivement par rapport à M2 et M3. Ensuite (figure 10), sur cette couche sacrificielle 111, le second masque 110 est déposé de manière conforme ou non. En fait, il faudra juste s'assurer que l'épaisseur déposée est suffisante pour protéger la surface extérieure du matériau M2 au niveau d'une zone entourant le corps du nanofil selon sa longueur au niveau de l'extrémité 105 du nanofil 101 opposée au substrat 108 dans l'exemple. Le matériau du second masque 110 est avantageusement du type M3, c'est-à-dire le même que celui utilisé pour le premier masque 109. M3 peut être gravé sélectivement par rapport à M5.

Avantageusement, le procédé comporte la formation d'une pluralité de transistors, chacun formé à partir d'un (ou plusieurs) nanofil 101 associé. Le second masque de gravure 110 est formé par le dépôt d'une couche formant, après retrait de la couche sacrificielle 111 (figure 10), une membrane suspendue (figure 7) reliant une pluralité de nanofils au niveau de leurs extrémités longitudinales opposées au substrat 108 avec interposition d'une partie du matériau M2 destiné à former le contact de source et le contact de drain.

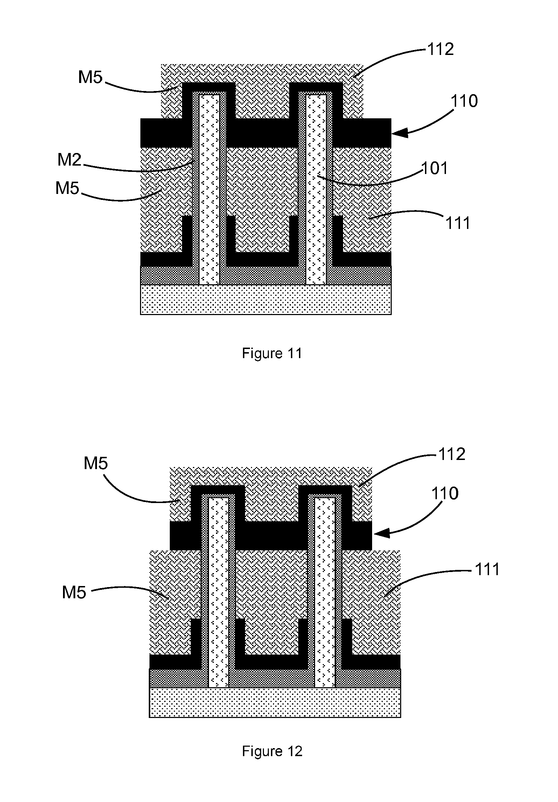

En fait, dans le cadre de la formation d'une membrane suspendue, celle-ci peut être délimitée avant le retrait de la couche sacrificielle 111 en matériau M5 de la figure 10. Les figures 11 et 12 illustrent une telle délimitation. Avantageusement, la délimitation permet de réduire la taille de la membrane à une surface configurée pour simplement englober et enrober toutes les extrémités de tous les nanofils 101 opposées au substrat 108 avec interposition du matériau M2. Cette limitation de la taille de la membrane permet d'éviter la rupture des nanofils entre les deux masques de gravure 109, 110 une fois la couche sacrificielle 11 retirée. A la figure 11, une résine photosensible 112 (qui pourrait aussi être remplacée par une résine électrosensible) est déposée, puis le dépôt de la résine 112 est suivi d'une lithographie. Cette résine sert de masque à la gravure d'une partie du second masque 110 pour délimiter la membrane. Le matériau utilisé comme résine photosensible est avantageusement de type M5. Ensuite, chaque partie du second masque 110 laissée libre est gravée (figure 12). Après délimitation de la membrane, la résine photosensible 112 et la couche sacrificielle 111 sont toutes les deux gravées avant gravure de M2 pour obtenir le résultat de la figure 7. L'avantage d'utiliser le matériau M5 en tant que couche sacrificielle 111 et résine photosensible 112 est qu'une simple étape de gravure par voie chimique ou physique suffit pour retirer ces deux dernières.

De manière générale, une fois le premier masque 109 et le second masque 110 délimités, le matériau M2 est gravé entre ces deux masques 109 et 110, par exemple par voie humide ou sèche, de sorte à délimiter le contact de source 102 et le contact de drain 105 au niveau de chaque nanofil (figure 7).

Une fois le contact de source 102 et le contact de drain 104 délimités, le premier masque 109 et le second masque 110 de la figure 7 peuvent être retirés de sorte à obtenir au moins un assemblage du type de la figure 5 comprenant au moins un nanofil.

En partant du cas où le contact de source 102 et le contact de drain 104 sont délimités pour chaque nanofil (figure 5), il est possible de réaliser la grille 106 comme décrit précédemment de sorte à obtenir le résultat de la figure 2.

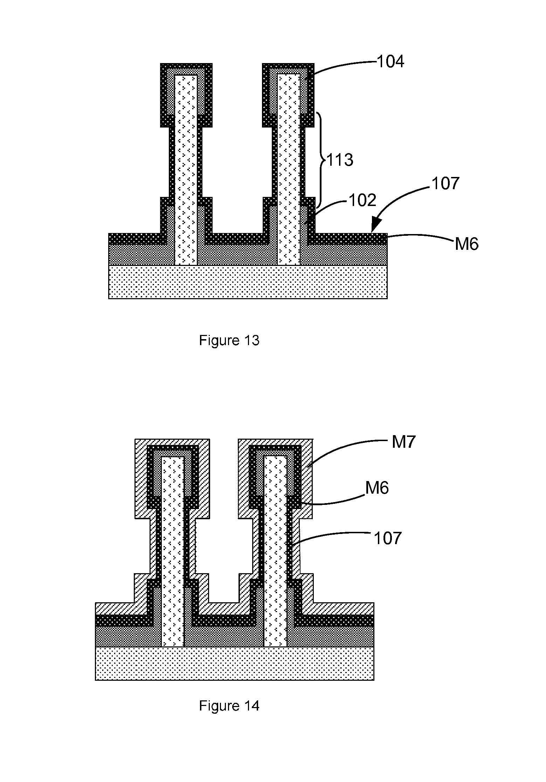

Selon une mise en oeuvre particulière, la phase de formation de la grille peut comporter une étape de dépôt (figure 13) d'un oxyde de grille 107, formant en outre le matériau M6 diélectrique, de sorte à recouvrir au moins le contact de source 102, le contact de drain 104 et la partie 113 de nanofil 101, située entre le contact de source 102 et le contact de drain 104. Cette partie 113 a, le cas échéant, été libérée par l'étape de gravure du matériau M2 destiné à former le contact de source 102 et le contact de drain 104. Ensuite, la phase de formation de la grille 106 peut comporter une étape de dépôt (figure 14), sur l'oxyde de grille 107, d'un matériau M7 destiné à former la grille, et enfin une étape de structuration du matériau M7 déposé sur l'oxyde de grille pour former la grille.

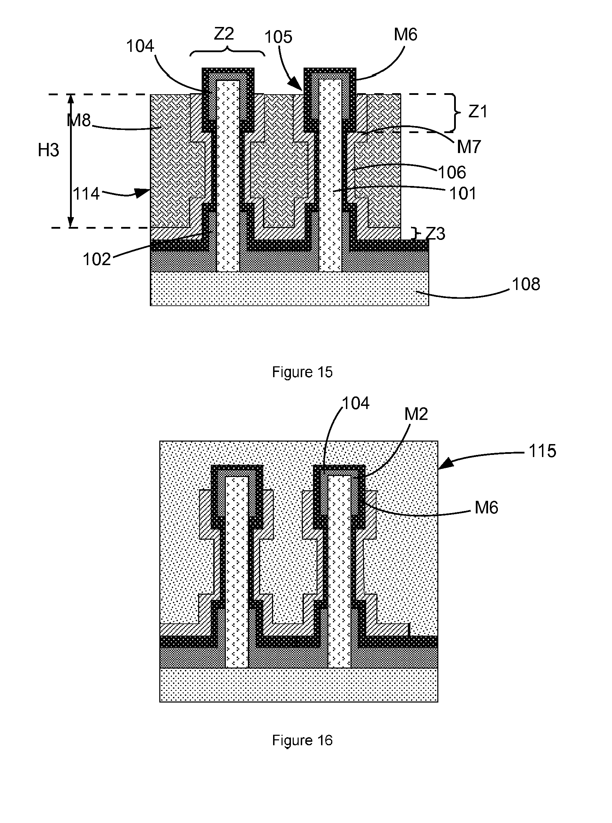

En fait, sur la figure 13, le matériau M6 est déposé de manière conforme de sorte à recouvrir le contact de source 102, le contact de drain 104, le nanofil entre les contacts de source et de drain, et avantageusement l'espace entre les nanofils lorsque ces derniers sont à un nombre supérieur ou égal à deux. Sur la figure 14, le matériau M7 est déposé par dépôt conforme de sorte à recouvrir le matériau M6, de préférence dans son intégralité. Le matériau M7 peut être gravé sélectivement par rapport au matériau M6. Comme illustré à la figure 15, la grille 106 peut alors être délimitée par un dépôt d'un masque de gravure 114 de la grille, puis par gravure (par exemple par voie sèche ou humide) d'une partie du matériau M7 non protégée par le masque de gravure de grille 114, et ce jusqu'au matériau M6. Le masque de gravure 114 peut être une résine déposée par tournage, ou un oxyde, ou un nitrure. La hauteur H3 de la couche formant masque de gravure de la grille 114 peut être abaissée à l'aide d'une gravure sèche de sorte à calculer de manière précise le recouvrement Z1 éventuel entre la grille 106 et le contact de drain 104. Le matériau utilisé pour former le masque de gravure 114 de la grille est désigné par M8. Le matériau M7 peut être gravé sélectivement par rapport au matériau M8.

Autrement dit, la structuration peut comprendre le retrait d'une partie du matériau M7 destiné à former la grille 106 recouvrant l'oxyde de grille 107 au niveau de l'extrémité longitudinale 105 du nanofil 101 opposée au substrat 108. Ce retrait du matériau M7 est réalisé, pour chaque nanofil, au niveau d'une zone Z2. Par ailleurs, une autre partie du matériau M7, destiné à former la grille, recouvrant l'oxyde de grille au niveau de la base du nanofil (c'est-à-dire au niveau du substrat 108) est aussi retirée, de sorte à faciliter l'accès au contact de source 102 au niveau du substrat 108 pour former une reprise de contact aussi appelée interconnexion de source. Sur la figure 15, ce retrait du matériau M7 au niveau du substrat est réalisé au niveau d'une zone Z3.

Ensuite, si le matériau M8 est une résine, il est retiré sélectivement par gravure sèche ou humide. Puis, chaque futur transistor est enrobé par un isolant 115 (figure 16) par exemple par dépôt PE-CVD ou CVD ou LPCVD ou pulvérisation cathodique ou pulvérisation magnétron. Dans le cas où le matériau M8 est un isolant, il peut être conservé et participer à l'enrobage avec un autre matériau déposé par la suite.

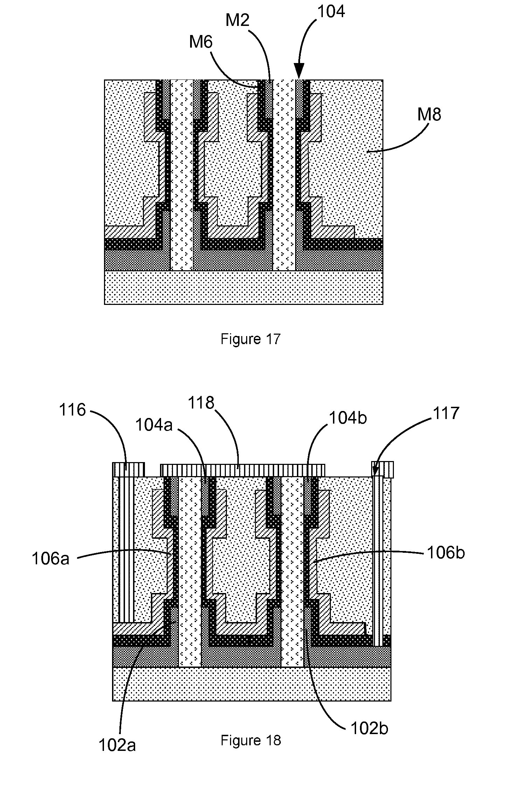

Le matériau M8 formant enrobage est ensuite abaissé par une gravure permettant de graver ledit matériau d'enrobage, le matériau M2 et le matériau M6 de sorte à laisser l'accès libre au contact de drain 104 (figure 17).

Les reprises de contact ou interconnexions de source, du drain et de la grille peuvent être réalisées. Ainsi, le procédé peut comporter une phase de formation d'interconnexions (figure 18) de grille 116, de source 117 et de drain 118, les interconnexions de source et de drain étant formées par retrait d'une partie de l'oxyde de grille au niveau des zones Z2 et Z3 où le matériau de grille a été retiré lors de la structuration de la grille. Après avoir retiré l'oxyde de grille, les interconnexions 116, 117, 118 peuvent être déposées et formées comme illustré à la figure 18.

Par interconnexion de source, de drain et de grille, on entend des liaisons électriques reliant le contact de source, le contact de drain et la grille à un circuit. Le circuit comporte alors d'autres éléments reliés électriquement au transistor via ces interconnexions

Avantageusement, on obtient à la fin du procédé un composant électronique comportant une pluralité de nanofils dont, comme à la figure 18, tous les contacts de source 102a, 102b sont reliés électriquement entre eux, tous les contacts de drain 104a, 104b sont reliés électriquement entre eux, et dont toutes les grilles 106a, 106b sont reliées électriquement entre elles.

Un support d'enregistrement de données lisible par un calculateur, sur lequel est enregistré un programme informatique peut comprendre des moyens de codes de programme informatique de mise en oeuvre des phases et/ou des étapes du procédé tel que décrit ci-dessus.

Un programme informatique peut comprendre un moyen de codes de programme informatique adapté à la réalisation des phases et/ou des étapes du procédé décrit ci-dessus, lorsque le programme est exécuté par un calculateur.

Comme indiqué auparavant pour le transistor, lors du procédé le contact de source et le contact de drain peuvent être inversés.

Il résulte de ce qui a été dit ci-avant que l'utilisation de deux masques durs dont un se présente avantageusement sous la forme d'une membrane suspendue au-dessus de l'autre par des nanofils permet de définir et de contrôler la longueur Lc du canal d'un transistor vertical grâce à un contrôle direct de l'espacement entre les contacts de drain et de source.

De plus réaliser une grille enrobante présentant un vis-à-vis le long du nanofil avec le contact de source et/ou le contact de drain tout en ajustant la surface du vis-à-vis permet un meilleur contrôle électrostatique du canal et des tensions de fonctionnement moins élevées.

De plus, le procédé décrit ici permet de maitriser les dimensionnements du canal, c'est-à-dire la position des contacts de source et de drain sur un nanofil.

## Revendications

1. Transistor (100) comprenant un nanofil (101) formant au moins partiellement un canal du transistor (100), un contact de source (102) disposé au niveau d'une première extrémité longitudinale (103) du nanofil (101), un contact de drain (104) disposé au niveau d'une seconde extrémité longitudinale (105) du nanofil (101), et une grille (106) disposée au niveau du nanofil (101) entre le contact de source (102) et le contact de drain (104), **caractérisé en ce qu'**une portion de la grille (106) recouvre, avec interposition d'un matériau diélectrique (107), une portion correspondante du contact de source (102) et/ou du contact de drain (104) disposée le long du nanofil (101) entre ses deux extrémités longitudinales (103, 105).

2. Transistor (100) selon la revendication 1, **caractérisé en ce que** la portion correspondante du contact de source (102) et/ou du contact de drain (104), disposée le long du nanofil (101) entre ses deux extrémités longitudinales (103, 105), est distincte du nanofil (101) et recouvre une partie de surface extérieure du nanofil (101).

3. Transistor selon l'une des revendications 1 ou 2, **caractérisé en ce que** le nanofil (101) comporte trois tronçons (T1, T2, T3) échelonnés selon sa longueur entre ses deux extrémités longitudinales (103, 105), un premier tronçon (T1) étant enrobé par le contact de source (102), un deuxième tronçon (T2) étant enrobé par le contact de drain (104), et un troisième tronçon (T3) étant enrobé au moins partiellement par la grille (106) avec interposition du matériau diélectrique (107).

4. Transistor selon la revendication 3, **caractérisé en ce que** la grille (106) enrobe aussi au moins partiellement, avec interposition du matériau diélectrique (107), le contact de source (102), et/ou le contact de drain (104).

5. Transistor selon l'une quelconque des revendications précédentes, **caractérisé en ce que** la longueur de la portion de grille (106) recouvrant, avec interposition du matériau diélectrique (107), la portion correspondante du contact de source (102) et/ou du contact de drain (103) est comprise entre 5% et 90% de la longueur dudit contact, et plus particulièrement entre 30% et 70%, lesdites longueurs de portions de grille et de contact étant orientées selon la longueur du nanofil.

6. Transistor selon l'une quelconque des revendications 3 à 5, **caractérisé en ce que** les contacts de source (102) et de drain (104) forment chacun un fourreau entourant respectivement les premier et deuxième tronçons (T1, T2) du nanofil, et **en ce que** la grille (106) entoure totalement au moins une partie du troisième tronçon (T3) du nanofil (101), et totalement au moins une portion du contact de source (102) et/ou du contact de drain (104) avec interposition du matériau diélectrique (107).

7. Composant semi-conducteur **caractérisé en ce qu'il** comprend au moins un transistor (100) selon l'une quelconque des revendications précédentes

8. Procédé de fabrication d'un transistor comprenant la phase suivante :
- Former (E1) un nanofil (101) destiné à servir au moins
partiellement de canal du transistor (100),
**caractérisé en ce qu'il** comporte les phases suivantes :
- Former (E2) simultanément un contact de source (102) au niveau d'une première extrémité longitudinale (103) du nanofil (101), et un contact de drain (104) au niveau d'une seconde extrémité longitudinale (105) du nanofil (101) opposée à la première extrémité longitudinale (103),
- Former (E3) une grille (106) de sorte qu'une portion de la grille (106) recouvre, avec interposition d'un matériau diélectrique (107), une portion correspondante du contact de source (102) et/ou de drain (104) disposée le long du nanofil (101) entre ses deux extrémités longitudinales (103, 105).

9. Procédé selon la revendication précédente, **caractérisé en ce que** la phase de formation (E2) du contact de source (102) et du contact de drain (104) comprend les étapes suivantes :
- Recouvrir la surface extérieure du nanofil (101), au moins selon sa longueur, d'un matériau (M2) destiné à former le contact de source (102) et le contact de drain (104),
- Graver ledit matériau (M2) destiné à former le contact de source (102) et le contact de drain (104) entre les deux extrémités longitudinales (103, 105) du nanofil (101) de sorte à délimiter le contact de source (102) et le contact de drain (104).

10. Procédé selon la revendication 9, **caractérisé en ce qu'**avant de graver le matériau (M2) destiné à former le contact de source et le contact de drain, la phase de formation (E2) du contact de source (102) et du contact de drain (104) comporte une étape de délimitation de la zone (113) à graver par formation de deux masques de gravure :
- un premier masque de gravure (109) étant formé sur une partie du matériau (M2) destiné à former le contact de source (102) et le contact de drain (104) au niveau d'une base du nanofil (101) située à une interface entre une des extrémités longitudinales du nanofil (101) et un substrat (108) à partir duquel s'élève le nanofil (101), et
- un second masque de gravure (110) étant formé sur une partie du matériau (M2) destiné à former le contact de source (102) et le contact de drain (104) au niveau de l'extrémité longitudinale du nanofil (101) opposée au substrat (108).

11. Procédé selon la revendication 10, **caractérisé en ce que** le second masque de gravure (110) est formé sur une couche sacrificielle (111) déposée, préalablement à la formation du second masque de gravure (110), sur le premier masque de gravure (109), et **en ce qu'**avant de réaliser l'étape de gravure du matériau (M2) destiné à former le contact de source (102) et le contact de drain (104), cette couche sacrificielle (111) est retirée.

12. Procédé selon la revendication précédente, **caractérisé en ce qu'il** comporte la formation d'une pluralité de transistors, chacun formé à partir d'un, ou plusieurs, nanofil (101) associé, et **en ce que** le second masque de gravure (110) est formé par le dépôt d'une couche formant, après retrait de la couche sacrificielle (111), une membrane suspendue reliant une pluralité de nanofils (101) au niveau de leurs extrémités longitudinales opposées au substrat (108) avec interposition d'une partie du matériau (M2) destiné à former le contact de source (102) et le contact de drain (104).

13. Procédé selon l'une des revendications 8 à 12, **caractérisé en ce que** la phase de formation de la grille (106) comporte :
- le dépôt d'un oxyde de grille, formant en outre le matériau diélectrique (107, M6), de sorte à recouvrir au moins le contact de source (102), le contact de drain (104) et la partie de nanofil (101) située entre le contact de source (102) et le contact de drain (104),
- le dépôt, sur l'oxyde de grille (107), d'un matériau (M7) destiné à former la grille (106),
- la structuration du matériau (M7) déposé sur l'oxyde de grille (107) pour former la grille (106).

14. Procédé selon la revendication 13 et la revendication 10, **caractérisé en ce que** la structuration comprend le retrait d'une partie du matériau (M7) destiné à former la grille (106) recouvrant l'oxyde de grille (107) au niveau de l'extrémité longitudinale du nanofil opposée au substrat (108), et d'une autre partie du matériau destiné à former la grille (106) recouvrant l'oxyde de grille au niveau de la base du nanofil (101).

15. Procédé selon la revendication 14, **caractérisé en ce qu'il** comporte une phase de formation (E4) d'interconnexions de grille (116), de source (117) et de drain (118), les interconnexions de source (117) et de drain (118) étant formées par retrait d'une partie de l'oxyde de grille (107) au niveau des zones (Z2, Z3) où le matériau de grille (M7) a été retiré lors de la structuration de la grille (106).

16. Support d'enregistrement de données lisible par un calculateur, sur lequel est enregistré un programme informatique comprenant des moyens de codes de programme informatique de mise en oeuvre des phases et/ou des étapes d'un procédé selon l'une des revendications 8 à 15.

17. Programme informatique comprenant un moyen de codes de programme informatique adapté à la réalisation des phases et/ou des étapes d'un procédé selon l'une des revendications 8 à 15, lorsque le programme est exécuté par un calculateur.
